# EUROPEAN PATENT APPLICATION

(11) **EP 3 187 779 A1**
(43) Date of publication of application: **05.07.2017**
(21) Application number: 15203198.5
(22) Date of filing: 30.12.2015
(51) Int. Cl.: F21V 25/12, H05B 37/02

(54) **EXPLOSION PROOF POWER SUPPLY UNIT FOR UNDERGROUND MINES**

(71) Applicant: Bomar S.A. w upadlosci ukladowej, 41-400 Myslowice (PL)
(72) Inventor: LESNIAK, Tomasz, 45-265 Opole (PL); MALOLEPSZY, Stanislaw, 43-600 Jaworzno (PL); NIEMCZYK, Piotr, 43-230 Goczalkowice-Zdroj (PL); WEGRZYNEK, Bogdan, 33-300 Nowy Sacz (PL)
(74) Representative: Korga, Leokadia

(57) **Abstract**

The invention relates to a supply power to device for use in underground mines.

The power supply device, characterized in that in the explosion-proof single chamber casing, a processor driver for regulating voltage is locked, and on the outside, the mode and power consumption display as a signal diode is arranged.

## Description

The invention relates to a supply power to device for use in underground mines.

Patent PL 158038 describes explosion proof electrical connector characterized in that a single-chamber body, whose walls are mounted on the threaded flameproof, pedestals cable entries having on its front to surface projections, which fall between the bent tabs on the base, embedded in the bottom the housing and on which are mounted push button switches, a terminal block and the flame-proof lens, wherein from the housing is derived from both of its sides, a control shaft to which are attached the ends of the bumper, which in turn are attached to the drive lever.

Patent PL 391887 describes explosion-cam characterized in that the cam is disposed within a housing with a sealable cover and fixed to the bottom by means of grooves and between adjoining edges of the housing and cover the entire circumference thereof is disposed elastic-elastic gasket material. The cover is provided outside a scroll wheel mounted on a threaded element to the coupling element, passing through the opening in the lid, and a coupling element connected to the drive shaft of the cam implementing wherein the hole from the inside of the cover (2) abuts arranged concentrically annular seal.

From the description of the utility model PL 120881 is known switchbox which is composed of a frame which has side walls, a top wall and a bottom wall. The interior of the switchbox is divided by horizontal plates and vertical partition walls into a number of chambers which is mounted electrical equipment. The bottom wall is a grid plate and is constructed of longitudinal strips and transverse strips, which have cross-sectional shape of the channel section. The horizontal plate has one or more pairs of openings. The side walls and the inner surface of the vertical divisions on both flat surfaces of the fastening strips are sockets. Vertical baffles are mounted in the grooves in the battens or studs holes of the horizontal plate of the patent.

An important issue in the mining industry is to construct a power supply unit protected in explosion proof housing..

Supply device according to the invention is characterized in that the explosion-proof single chamber housing, the driver is installed, the processor adjusting the voltage and is arranged outside the display mode and power consumption as a signal diode.

The device has been minimized processor system control and display elements are made in the form of a signaling LED.

## Claims

1. The power supply unit, **characterized in that** in the explosion-proof single chamber casing, a processor driver for regulating voltage is locked, and on the outside, the mode and power consumption display as a signal diode is arranged.
